# FASCICULE DE BREVET EUROPEEN

(11) **EP 0 589 748 B1**
(45) Date de publication et mention de la délivrance du brevet: **16.07.1997**
(21) Numéro de dépôt: 93402204.7
(22) Date de dépôt: 10.09.1993
(51) Int. Cl.: H01L 21/60

(54) **Procédé pour permettre le montage d'une puce sur un substrat**
Verfahren zur Vorbereitung der Montage eines Chips auf einem Substrat
Process preparing a chip to be mounted on a substrate

(30) Priorité: 25.09.1992 FR 9211447
(43) Date de publication de la demande: 30.03.1994
(73) Titulaire: THOMSON-CSF, 75008 Paris (FR)
(72) Inventeur: Grancher, Alain, F-92402 Courbevoie Cédex (FR); Michel, Ludovic, F-92402 Courbevoie Cédex (FR)
(74) Mandataire: Courtellemont, Alain

(56) Documents cités:
- EP-A- 0 435 009
- WO-A-91/00619
- US-A- 3 621 565
- IBM TECHNICAL DISCLOSURE BULLETIN, vol. 26, no. 3B, Août 1983, New York US, page 1548; H. ANDRES et al.: 'Cooling system for semiconductor modules'

## Description

La présente invention se rapporte à un procédé pour permettre un montage de type puce à bosses (flip-chips dans la littérature anglo-saxonne) d'une puce sur une face d'un substrat récepteur généralement constitué d'une céramique isolante associée à des pistes conductrices. Le montage de type puce à bosses est connu ; il conduit à un assemblage dans lequel celle des faces de la puce qui comporte les accès de la puce est en regard du substrat récepteur.

Il est connu de réaliser un montage de type puce à bosses à l'aide de la technique dite de "ball-bonding" qui consiste à réaliser des liaisons électriques au moyen de fils d'or dont une extrémité a été fondue, par exemple au moyen d'un arc électrique, pour former une petite boule ; dans le cas d'une puce cette boule est alors pressée sur un accès de la puce, pour constituer un plot qui est amené en contact à l'endroit désiré du substrat récepteur sur lequel doit être montée la puce. C'est ainsi qu'il est connu, par la demande PCT WO-A-91-00619, d'effectuer sur chaque accès d'une puce une soudure d'une boule d'or obtenue par fusion de l'extrémité d'un fil d'or puis de rompre le fil à une certaine distance de la boule. La puce a alors, sur chacun de ses accès, une boule d'or et un brin de fil d'or disposé sensiblement perpendiculairement à la face de la puce portant les accès. La puce, ainsi préparée, est destinée à être montée sur un substrat récepteur muni de trous métallisés disposés de manière à recevoir chacun un des brins de fil d'or qui vient en contact avec les parois du trou métallisé dans lequel il est introduit. Avec une puce ainsi préparée il est très difficile de réaliser le montage sur le substrat récepteur étant donné que les brins de fil d'or ont tendance à ne pas rester bien perpendiculaires à la face portant les accès et qu'alors il devient impossible de les introduire simultanément dans les trous du substrat récepteur.

Il est d'autre part connu par le document IBM TDB vol.26 n°3B, Août 1983 page 1548, d'effectuer un montage dans lequel, pour des problèmes de dissipation thermique, des puces sont montées sur un radiateur avec leur face arrière plaquée sur le radiateur et leur face avant à une certaine distance de la face d'un substrat; à chaque accès de la puce est associée une boule de soudure prolongée par un conducteur filaire dont la longueur est suffisante, compte tenu de la distance puce-substrat, pour que son extrémité libre puisse être soudée à l'endroit voulu du substrat. Il ne s'agit pas, à proprement parler, du montage d'une puce sur un substrat mais du montage d'une puce sur un radiateur et d'un radiateur sur un substrat ; et la mise en oeuvre de cette technique est délicate étant donné que le radiateur, de par sa présence, constitue une gêne importante lors de l'opération qui consiste à souder les extrémités libres des conducteurs filaires sur le substrat.

La présente invention a pour but d'éviter ou, pour le moins, de réduire ces inconvénients.

Ceci est obtenu en préparant différemment la puce de telle sorte que les brins d'or ne constituent plus un handicap lors du montage de la puce mais servent de repères pour positionner la puce lors de son montage sur un substrat récepteur.

Selon l'invention ceci est obtenu par le procédé de montage tel que décrit dans la revendication 1.

La présente invention sera mieux comprise et d'autres caractéristiques apparaîtront à l'aide de la description ci-après et des figures s'y rapportant qui représentent :
- les figures 1 à 6, des étapes de préparation d'une puce en vue de son montage sur un substrat,
- les figures 7 à 9, des étapes du montage sur un substrat récepteur d'une puce préparée selon les étapes de préparation illustrées par les figures 1 à 6.

Sur les différentes figures les éléments correspondants sont désignés par les mêmes repères ; par ailleurs dans certaines figures les dimensions n'ont pas été respectées dans un souci de meilleure visibilité et donc de meilleure compréhension.

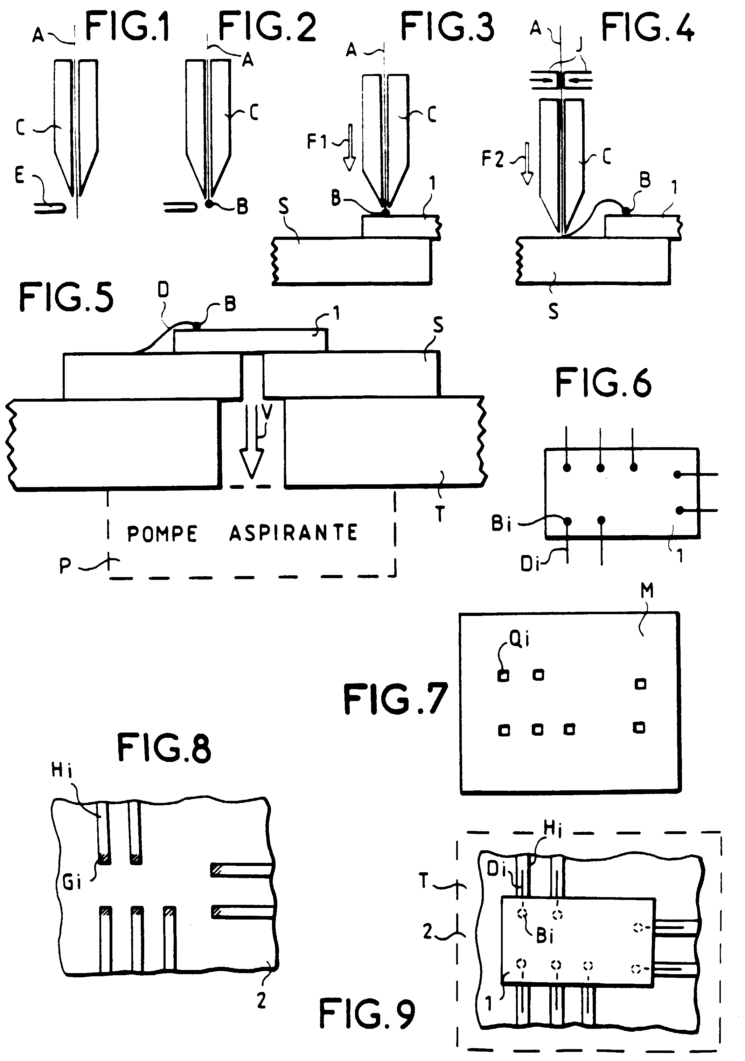

La figure 1 est un schéma partiel, en coupe, d'une machine pour effectuer du "ball-bonding", qui montre un passe-fil C et une électrode E. Le passe-fil est également appelé capillaire du fait qu'il est percé d'un trou très fin qui sert à amener l'extrémité d'un fil d'or, A, au voisinage de l'électrode E; ce fil d'or, A, qui dans l'exemple décrit fait 25 microns de diamètre, provient d'une bobine et est relié à l'une des bornes d'un générateur de courant, non représenté, dont l'autre borne est reliée à l'électrode E pour produire un arc électrique entre l'extrémité du fil d'or et l'électrode. D'autres machines pour effectuer du "ball-bonding" existent dans lesquels le dispositif pour produire un arc électrique est remplacé par un chalumeau ; la tête du chalumeau est disposée à l'emplacement de l'électrode E et sa flamme est dirigée sur l'extrémité du fil A.

L'arc électrique fait fondre l'extrémité du fil A, ce qui produit une boule B comme représenté sur la figure 2 ; cette boule a, dans l'exemple décrit, un diamètre d'environ 50 microns.

La boule B est alors soudée sur un des accès d'une puce 1, comme représenté sur la vue en coupe de la figure 3. Pour cela la puce 1 est au préalable placée sur un substrat intermédiaire, S, aussi appelé substrat outil et le substrat intermédiaire est placé sur une plaque chauffante, non représentée sur la figure 3 mais qui apparaîtra sur la figure 5 ; le passe-fil C est abaissé, selon la flèche F1, pour venir presser la boule B à l'endroit choisi de la puce 1. Pendant les opérations de soudure une source d'ultrasons de niveau réglable, non représentée, est reliée au passe-fil C pour faciliter les soudures.

La figure 4 montre que, dans la suite des opérations, une partie du fil d'or A, solidaire de la boule B, est extraite du passe-fil C et que le passe-fil est abaissé, selon la flèche F2, pour venir écraser le fil A sur le substrat intermédiaire, S, afin d'assurer sa fixation par soudure sur la pellicule d'or que comporte le substrat S sur sa face en contact avec la puce 1. Après cette soudure avec écrasement, le passe-fil est relevé en même temps qu'une pince J solidaire du passe-fil et qui n'a été représentée que sur la figure 4, se referme bloquant le fil ; il en résulte une rupture du fil d'or à la sortie du passe-fil C. Il est à noter que cette soudure est volontairement réalisée de façon imparfaite par réglage de la pression d'écrasement, du niveau et de la durée des ultrasons, afin de pouvoir la "décoller" facilement par la suite.

La figure 5 montre la liaison réalisée par la boule B et un segment de fil D entre la puce 1 et le substrat intermédiaire S ; il s'agit de la liaison obtenue selon le procédé décrit à l'aide des figures 1 à 4. La figure 5 est une vue en coupe qui permet de voir comment la puce 1 et le substrat intermédiaire S sont disposés sur une plaque chauffante T portée à 110°C, pour réaliser les opérations décrites à l'aide des figures 3 et 4 : la plaque chauffante T et le substrat intermédiaire S sont percés chacun d'un trou et les deux trous sont placés l'un au-dessus de l'autre - la puce 1 est disposée sur le substrat intermédiaire S, au-dessus des deux trous - une pompe aspirante, P, située sous la plaque S et créant une dépression figurée par une flèche V, maintient en position l'ensemble puce-substrat intermédiaire sur la plaque chauffante.

Après que les liaisons relatives à chacun des accès de la puce 1 aient été réalisées, la puce est séparée de son substrat intermédiaire et se présente comme indiqué sur la figure 6 ou apparaissent sept ensembles boule-segment de fil tels que l'ensemble Bi-Di. Cette séparation est rendue possible en raison de la soudure imparfaite réalisée lors de l'étape du procédé décrite à l'aide de la figure 4. Il est à remarquer que les segments de fils tels que Di sont disposés perpendiculairement au bord le plus proche de l'accès sur lequel est soudée la boule dont ils sont solidaires.

Dans la mesure où le procédé est destiné à permettre un montage de type puce à bosses, il peut s'arrêter à l'obtention de la puce selon la figure 6 ; en effet une telle puce peut être commercialisée telle quelle pour permettre des montages de types puce à bosses : grâce aux segments de fils tels que Di elle permettra de positionner facilement la puce sur le substrat récepteur et grâce aux boules telles que Bi elle permettra d'assurer une bonne liaison par soudure entre les accès de la puce et les points en regard du substrat récepteur.

Le procédé peut également être poursuivi de la façon préconisée ci-après et illustrée, par les figures 7, 8 et 9, afin d'assurer un montage de type puce à bosses jusqu'à son terme.

Par sérigraphie à l'aide d'un pochoir, M, réalisé par photogravure une crème à souder est déposée aux endroits d'un substrat récepteur destinés à être en contact avec les boules d'or, Bi, de la puce 1. Le pochoir M est représenté sans son cadre sur la figure 7 ; il permet le dépôt de la crème à souder aux endroits voulus du substrat récepteur et est percé pour cela de trous, tels que Qi, obtenus lors de la photogravure.

La figure 8 montre une partie d'un substrat récepteur 2 destiné à recevoir la puce 1 selon la figure 6 et comportant, à cet effet, des pistes conductrices telles que Hi. Le substrat 2 est représenté après que des petits dépôts de crème à souder, tels que Gi, aient été obtenus en différents endroits de sa surface à l'aide du pochoir selon la figure 7 ; sur la figure 8 ces dépôts sont représentés par de petites surfaces hachurées. Dans l'exemple décrit la crème à souder est un mélange à 88% de métal et 12% de liant et de résine avec, pour la partie métal, 80% d'indium, 15% de plomb et 5% d'argent.

La figure 9 montre la puce 1 de la figure 6 posée sur le substrat récepteur 2 de la figure 8, lui-même placé sur une plaque chauffante, T, représentée par un contour en traits interrompus qui ne délimite qu'une partie de la plaque chauffante ; cette plaque est portée à 170°C. Comme il apparaît sur cette figure, les segments de fils tels que Di constituent de bons repères pour positionner la puce 1 sur son substrat récepteur 2. La plaque chauffante T sert à produire une fusion de la crème à souder et ainsi à donner des soudures au niveau des dépôts de crème à souder c'est-à-dire là où les boules, telles que Bi, de la puce 1 et les pistes conductrices du substrat récepteur 2 sont en contact. Le montage ainsi obtenu est, au choix, recouvert d'une résine de protection ou protégé par un capot isolant scellé.

D'autre procédés, qui ne sont pas revendiqués, sont décrits ci-après. Le substrat intermédiaire n'est pas indispensable, la puce selon la figure 6 pouvant être préparée par soudure de boules, telles que Bi, auxquelles sont laissés attachés des segments de fil, tels que Di, obtenus simplement en coupant à longueur voulue le fil d'or provenant du passe-fil de la machine à effectuer du "ball-bonding" et en pliant ce segment de fil pour l'amener dans une position prédéterminée.

De même le procédé de montage peut être mis en oeuvre en soudant seulement une boule par accès de la puce, c'est-à-dire sans segment de fil, mais dans ce cas il est plus difficile de positionner la puce lors de la phase finale du montage puce à bosses et une machine à positionner cette puce devient obligatoire.

## Revendications

1. Procédé pour permettre un montage de type puce à bosses d'une puce sur une face d'un substrat récepteur, ce type de montage étant celui dans lequel celle des faces de la puce qui comporte les accès de la puce est en regard de la face du substrat récepteur, ce procédé consistant d'abord à effectuer sur chaque accès de la puce, une soudure d'une boule d'or (B ; Bi) obtenue par fusion de l'extrémité d'un fil d'or (A), la soudure étant réalisée en pressant la boule d'or sur l'accès considéré, caractérisé en ce qu'il consiste ensuite à effectuer un positionnement de la puce (1) sur un substrat intermédiaire (S) dit substrat outil, à effectuer de manière imparfaite, une soudure entre un point prédéterminé du substrat outil et une partie du fil d'or située à une certaine distance de la boule considérée (B), à provoquer une rupture du fil d'or de manière à ne conserver qu'un segment du fil d'or, ce segment étant limité à la boule d'or et à la soudure imparfaite et à séparer la puce (1) du substrat outil (S) en décollant les soudures réalisées de manière imparfaite.

2. Procédé selon la revendication 1, caractérisé en ce qu'il consiste à utiliser, comme substrat outil, un substrat outil (S) percé d'un trou, à utiliser un plateau chauffant (T) muni d'un dispositif d'aspiration (P), et à effectuer le positionnement en disposant le trou du substrat outil au-dessus du dispositif d'aspiration et la puce (1) au-dessus du trou.

3. Procédé selon l'une des revendications précédentes, caractérisé en ce qu'il consiste à déposer sur le substrat récepteur (2), en des zones conductrices prévues pour être en contact avec les accès de la puce, une crème à souder (Gi), à effectuer un positionnement de la puce (1) sur le substrat récepteur afin d'obtenir des ensembles constitués d'une des boules d'or (Bi), de crème à souder (Gi) et d'une des zones conductrices, et à effectuer une fusion au niveau de ces ensembles.

## Claims

1. Process for allowing mounting, of the flip-chip type, of a chip on one face of a receiving substrate, this type of mounting being that in which that one of the faces of the chip which has the chip contacts is opposite the face of the receiving substrate, this process firstly consisting in bonding, at each chip contact, a gold ball (B ; Bi) obtained by melting the end of a gold wire (A), the bonding being produced by pressing the gold ball against the contact in question, characterized in that it subsequently consists in positioning the chip (1) on an intermediate substrate (S), called tool substrate, in making, imperfectly, a bond between a predetermined point on the tool substrate and part of the gold wire lying at a certain distance from the ball (B) in question, in breaking the gold wire so as to preserve only a segment of the gold wire, this segment being limited to the gold ball and to the imperfect bond, and in separating the chip (1) from the tool substrate (F) by disbonding the imperfectly produced bonds.

2. Process according to Claim 1, characterized in that it consists in using, as tool substrate, a tool substrate (S) pierced with a hole, in using a heating plate (T) provided with a suction device (P) and in positioning it by placing the hole in the tool substrate over the suction device and the chip (1) over the hole.

3. Process according to either of the preceding claims, characterized in that it consists in depositing a solder cream (Gi) on the receiving substrate (2) in conducting areas provided for coming into contact with the chip contacts, in positioning the chip (1) on the receiving substrate, so as to obtain assemblies consisting of one of the gold balls (Bi), solder cream (Gi) and one of the conducting areas, and in causing melting in the region of these assemblies.

## Patentansprüche

1. Verfahren für die Flip-Chip-Montage eines Chips auf eine Fläche eines Trägersubstrats, wobei die Seite des Chips, die die Zugänge des Chips trägt, vor der Fläche des Trägersubstrats liegt, und wobei gemäß diesem Verfahren zuerst an jedem Zugang des Chips eine Goldkugel (B; Bi) angelötet wird, die durch Schmelzen des Endes eines Golddrahts (A) erhalten wurde, indem die Goldkugel auf den betreffenden Zugang gepreßt wird, dadurch gekennzeichnet, daß dann der Chip (1) auf einem Zwischensubstrat (S), genannt Werkzeugsubstrat, angeordnet und in unvollkommener Weise eine Verlötung zwischen einem vorbestimmten Punkt des Werkzeugsubstrats und einem Teil des Golddrahts durchgeführt wird, der sich in einem bestimmten Abstand von der betreffenden Kugel (B) befindet, daß dann der Golddraht abgetrennt wird, um nur ein Segment des Golddrahts zu behalten, wobei dieses Segment auf die Goldkugel und die unvollkommene Lötstelle begrenzt ist, und daß man den Chip (1) vom Werkzeugsubstrat (S) trennt, indem die unvollkommenen Lötstellen abgelöst werden.

2. Verfahren nach Anspruch 1, dadurch gekennzeichnet, daß als Werkzeugsubstrat ein mit einem Loch versehenes Werkzeugsubstrat (S) verwendet wird, daß man eine mit einer Ansaugvorrichtung (P) versehene Heizplatte (T) verwendet und die Positionierung durchführt, indem das Loch des Werkzeugsubstrats oberhalb der Ansaugvorrichtung und der Chip (1) oberhalb des Lochs angeordnet wird.

3. Verfahren nach einem der vorhergehenden Ansprüche, dadurch gekennzeichnet, daß auf das Trägersubstrat (2) in leitenden Zonen, die mit den Zugängen des Chips in Kontakt gelangen sollen, eine Lötpaste (Gi) aufgebracht wird, daß man dann den Chip (1) auf dem Trägersubstrat positioniert, um Einheiten zu erhalten, die aus einer der Goldkugeln (Bi), Lötpaste (Gi) und einer der leitenden Zonen bestehen, und daß man schließlich in Höhe dieser Einheiten die Paste zum Schmelzen bringt.
